Europäisches Patentamt

**European Patent Office**

**Office européen des brevets**

(19)

(11) Numéro de publication : **0 146 175**
**B1**

(12)

# FASCICULE DE BREVET EUROPÉEN

(45) Date de publication du fascicule du brevet :
**27.07.88**

(51) Int. Cl.⁴ : **G 01 R 31/11, H 03 H 21/00**

(21) Numéro de dépôt : **84201765.9**

(22) Date de dépôt : **03.12.84**

(54) **Dispositif de localisation d'un point de réflexion de signal sur une ligne de transmission.**

(30) Priorité : **07.12.83 FR 8319570**

(43) Date de publication de la demande :
**26.06.85 Bulletin 85/26**

(45) Mention de la délivrance du brevet :
**27.07.88 Bulletin 88/30**

(84) Etats contractants désignés :
**CH DE FR GB IT LI NL SE**

(56) Documents cités :
**DE-A- 2 060 159**
**FR-A- 2 458 079**
**US-A- 4 041 381**
**INTERNATIONAL JOURNAL OF ELECTRONICS, vol. 55, no. 3, septembre 1983, Basingstoke, Hampshire, GB; B.V. RAO et al.: "A new design for digital adaptive filters", pages 473-477**
**1982 INTERNATIONAL SYMPOSIUM ON CIRCUITS AND SYSTEMS (IEEE), vol. 2, Rome 10-12 mai 1982, D. MANSOUR et al.: "Performance characteristics of the unconstrained frequency domain adaptive filter", pages 695-697**

(73) Titulaire : **TELECOMMUNICATIONS RADIOELECTRIQUES ET TELEPHONIQUES T.R.T.**
**88, rue Brillat Savarin**
**F-75013 Paris (FR)**

(72) Inventeur : **Lassaux, Jean**
**SOCIETE CIVILE S.P.I.D. 209 rue de l'Université**
**F-75007 Paris (FR)**
Inventeur : **Clement, Henry**
**SOCIETE CIVILE S.P.I.D. 209 rue de l'Université**
**F-75007 Paris (FR)**

(74) Mandataire : **Chaffraix, Jean et al**
**Société Civile S.P.I.D. 209, rue de l'Université**
**F-75007 Paris (FR)**

# 0 146 175

**Description**

L'invention concerne un dispositif destiné à localiser et/ou caractériser un point de réflexion sur une ligne de transmission par l'enregistrement de la réponse impulsionnelle du trajet d'un écho engendré audit point de réflexion en réponse à un signal d'émission, ce dispositif comportant une voie d'émission et une voie de réception couplées à la ligne de transmission par un circuit de couplage, le signal d'émission étant déduit d'un signal de référence constitué de séquences binaires de même durée NT au moins égale au double du temps de propagation dans la ligne de transmission, N étant un nombre entier, T étant la durée d'un élément binaire.

Le dispositif envisagé peut être utilisé notamment pour localiser et caractériser un défaut sur une ligne de transmission. On sait en effet que si, en un point quelconque d'une ligne de transmission, il se produit un défaut engendrant une irrégularité des paramètres électriques, la valeur de l'impédance caractéristique en ce point est modifiée et toute onde incidente donne lieu à une onde réflective appelée « écho ». Une mesure, à l'origine de la ligne de transmission, du temps séparant l'émission d'une onde incidente et le retour de l'onde réfléchie permet donc, connaissant la vitesse de propagation, de déterminer la distance entre le lieu de mesure et l'endroit du défaut. En outre, les caractéristiques de phase et d'amplitude de l'onde réfléchie permettent de déterminer la nature du défaut (court-circuit, circuit ouvert ou mise à la terre) et son intensité.

Parmi les dispositifs utilisant des mesures d'écho pour localiser et caractériser les défauts sur les lignes de transmission, on connaît des appareils de chantier relativement rudimentaires dans lesquels la localisation et la caractérisation du défaut sont effectuées par un opérateur observant un écran de visualisation sur lequel apparaît le signal d'écho reçu, en réponse à une impulsion émise.

Ce genre d'appareil nécessite souvent un réglage manuel de l'impédance d'équilibrage du circuit de couplage tandis que les mesures peuvent être très perturbées par le bruit en ligne. D'autre part, avec ce type d'appareil, on ne peut envisager par exemple une maintenance automatique de toutes les lignes d'abonnés connectées à un central téléphonique. Il est nécessaire pour cela que, comme dans le dispositif envisagé, toutes les mesures d'écho soient enregistrées automatiquement dans une mémoire, sous forme numérique, en vue d'un traitement ultérieur par un ordinateur.

Dans le brevet américain US-A-4041381, il est décrit également un appareil permettant de localiser et de caractériser un défaut sur une ligne de transmission. Dans cet appareil, on émet sur la ligne de transmission une suite de séquences identiques dont la fonction d'autocorrélation a une fonction d'impulsion. On effectue des calculs de corrélation entre le signal reçu et les séquences émises successivement retardées par des échelons de temps 'jusqu'à trouver dans le signal calculé un pic indiquant la corrélation entre le signal émis et le signal reçu. Ce procédé peut fournir un enregistrement numérique de la réponse impulsionnelle du trajet d'écho, mais il a l'inconvénient de nécessiter un volume de calcul et de mémoire important et d'être en outre sensible aux bruits sur la ligne de transmission, ce qui limite la distance maximale du défaut détectable.

La présente invention a pour but de fournir un dispositif qui puisse être aisément mis en œuvre dans un système de maintenance automatique de lignes de transmission, en évitant les inconvénients des dispositifs connus.

Conformément à l'invention, un dispositif destiné à localiser et/ou à caractériser un point de réflexion de signal sur une ligne de transmission est caractérisé en ce que les séquences binaires du signal de référence ne comportant qu'un seul élément de valeur non nulle égale à 1 (ou alternativement 1 et — 1) et du côté réception, il est prévu une mémoire pour N coefficients Ci (i entier allant de 0 à N — 1) qui sont lus cycliquement à des instants nT = (KN + j)T en vue d'être modifiés par récurrences successives, n entier allant de — ∞ à + ∞ et caractérisant chaque cycle de lecture, j entier allant de 0 à N — 1 et caractérisant l'instant de lecture dans un cycle de lecture, des moyens de comparaison formant à chaque instant nT la différence e(n) entre le signal reçu et chaque coefficient lu converti en analogique ou le signe de e(n), Sgn [e(n)], des moyens étant prévus pour modifier chaque coefficient Ci une fois par cycle de lecture, à des instants tels que j = i, au moyen d'un terme de modification additif égal à α · e(n) ou α · Sgn [e(n)], α étant un coefficient inférieur à 1, les coefficients lus étant après chaque modification inscrits dans ladite mémoire, les coefficients Ci inscrits dans la mémoire constituant, après un nombre suffisant de modifications, les valeurs (ou les valeurs au signe pris) à des instants iT de la réponse impulsionnelle du trajet d'écho.

Pour tester des lignes de transmission engendrant des distorsions qui peuvent déformer l'écho reçu, il est avantageux, selon une variante de l'invention, que le signal d'émission soit une version filtrée du signal de référence, avec une fonction de filtrage déterminée pour compenser au moins de façon approximative les distorsions produites par les lignes de transmission à tester, la réponse impulsionnelle correspondant à cette fonction de filtrage s'étendant au plus sur la durée NT des séquences composant le signal de référence.

Pour s'affranchir des bruits et dérives à basse fréquence dont peuvent être affectés les coefficients modifiés, le dispositif de l'invention comporte avantageusement un circuit accumulateur pour former à partir d'un certain temps et pendant un certain nombre de récurrences lues, la somme de chacun des coefficients Ci modifiés, les valeurs moyennes des coefficients Ci étant déduites des sommes ainsi formées pour être utilisées comme valeurs de la réponse impulsionnelle du trajet d'écho.

La description suivante en regard des dessins annexés, le tout donné à titre d'exemple, fera bien comprendre comment l'invention peut être réalisée.

La figure 1 représente un schéma du dispositif de l'invention.

La figure 2 représente en 2a et 2b des diagrammes de deux formes possibles pour le signal de référence utilisé dans le dispositif de l'invention.

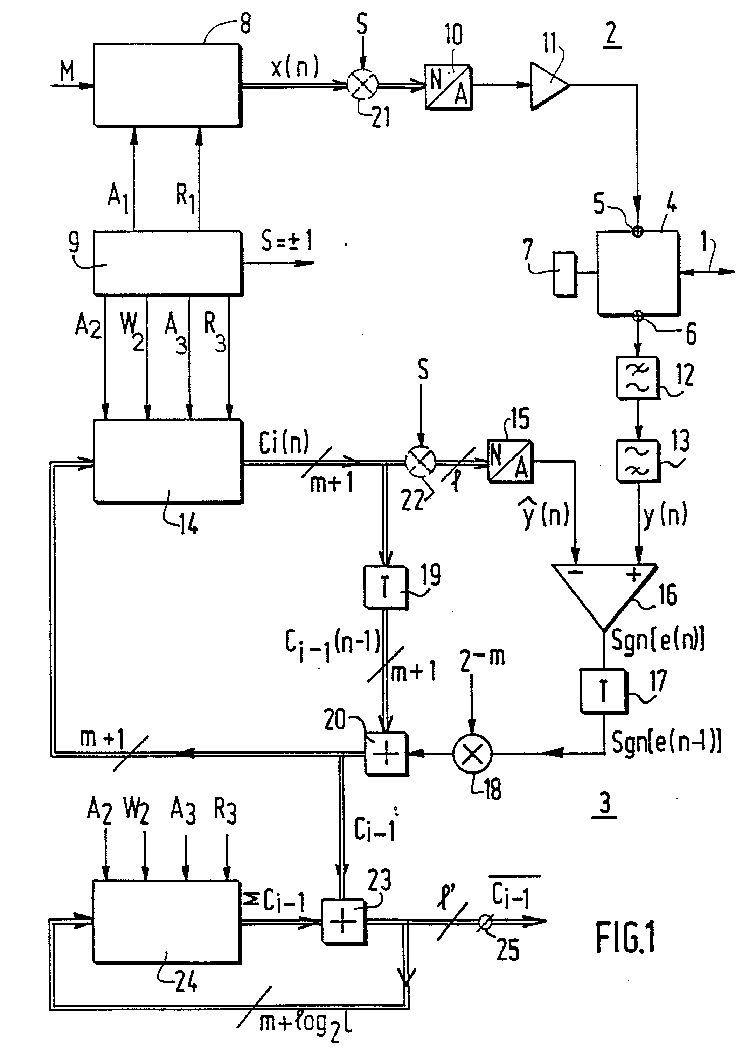

Le dispositif de l'invention représenté sur la figure 1 a pour but de localiser et/ou de caractériser un point de réflexion de signal sur la ligne de transmission 1, ce point de réflexion étant engendré par exemple par un défaut sur la ligne de transmission. Ce dispositif comporte une voie d'émission 2 et une voie de réception 3 qui sont couplées à la ligne de transmission 1 au moyen d'un circuit de couplage 4, via les bornes d'émission 5 et de réception 6 de ce circuit de couplage. Le circuit de couplage 4, connu en soi, est muni d'une impédance d'équilibrage 7 qui, lorsqu'elle est convenablement réglée, permet d'aiguiller quasiment tout le signal d'émission vers la ligne 1, en évitant que ce signal ne parvienne directement à la voie de réception 3. Dans ces conditions, si un signal est reçu sur l'extrémité 6 du circuit de couplage, il ne peut provenir pratiquement que d'un écho engendré sur la ligne de transmission, notamment par un défaut, en réponse à un signal émis en direction de cette ligne.

Le dispositif de l'invention a pour but de fournir sous forme numérique un enregistrement de la réponse impulsionnelle du trajet d'écho, en vue d'en déduire la distance et le caractère du défaut ayant engendré l'écho.

Le temps d'observation de cette réponse impulsionnelle doit s'étendre depuis l'instant d'émission d'une impulsion jusqu'à l'instant de réception de l'impulsion réfléchie, pour la ligne de transmission la plus longue à tester. Par exemple, pour tester les lignes téléphoniques ayant une longueur maximale de 10 km et dans lesquelles la vitesse de propagation est de 200 m/µs, on voit aisément qu'un temps d'observation de l'ordre de 100 µs convient. Dans les mêmes conditions, on peut voir que si une précision de 100 m est requise pour la localisation d'un point de réflexion, la mesure de l'instant de retour de l'écho doit être effectuée avec une précision de 1 µs.

La voie d'émission 2 comporte un générateur 8 du signal de référence. Ce signal de référence est constitué de séquences binaires de même durée NT, N étant un nombre entier et T étant égale à la durée d'un élément binaire. La durée NT d'une séquence est au moins égale au double du temps de propagation Z dans la longueur maximale de la ligne de transmission, afin que pendant la durée d'une séquence, on puisse observer à la fois un écho et le signal émis ayant provoqué cet écho. Dans l'exemple précité d'une longueur maximale de ligne de 10 km et d'une vitesse de propagation de 200 m/µs la durée NT de chaque séquence doit être au moins de 100 µs ; une précision de 100 m pour la localisation correspondante requiert une durée T = 1 µs pour chaque élément binaire de sorte que chaque séquence doit comporter au moins N = 100 éléments binaires. Le générateur 8 peut être par exemple une mémoire stockant à N adresses les éléments binaires formant une séquence. Cette mémoire est lue à l'aide du signal d'adresses AI et du signal de lecture RI fourni par le générateur de signal de commande 9, de façon qu'à la sortie de la mémoire des éléments binaires apparaissent à la fréquence 1/T et les séquences à la fréquence 1/NT. Le signal de référence ainsi formé prend les valeurs x(n) aux instants NT.

Le signal x(n) est appliqué au convertisseur numérique-analogique 10 et le signal analogique obtenu, amplifié dans l'amplificateur 11 est dirigé sur la ligne de transmission 1 par l'intermédiaire du circuit de couplage 4.

La voie de réception 5 comporte à son entrée un dispositif de filtrage composé du filtre passe-bas 12 et du filtre passe-haut 13 pour éliminer du signal reçu les composantes de fréquences situées hors de la bande utile de la ligne de transmission.

Dans le dispositif connu, décrit dans le brevet américain précité n° 4041381, les séquences du signal x(n) ont une fonction d'autocorrélation présentant une fonction d'impulsion et on calcule la fonction de corrélation entre le signal reçu et les séquences émises, successivement retardées l'une par rapport à l'autre d'échelons de temps. Si l'on trouve une corrélation entre le signal reçu et des séquences émises retardées d'un échelon de temps, on peut en déduire la réponse impulsionnelle du trajet d'écho. Les calculs de corrélation effectués selon ce procédé nécessitent un volume important de calcul et de mémoire et d'autre part, rien ne semble fait pour diminuer la sensibilité du dispositif aux bruits sur la ligne de transmission.

Ces inconvénients sont évités avec le dispositif de l'invention, grâce à une adpatation judicieuse des techniques utilisées dans les annuleurs d'écho adaptatifs. Avant de décrire la structure et le fonctionnement du dispositif de l'invention, on va rappeler le principe général d'un annuleur d'écho adaptatif.

On suppose qu'un signal prenant les valeurs x(n) à des instants nT est engendré sur la voie d'émission 2 en direction de la ligne de transmission 1. Si un écho se produit sur cette ligne, le signal y(n) reçu sur la voie réception 3 aux instants nT peut s'écrire :

$$y(n) = \sum_{i=0}^{\infty} hi \cdot x(n-i) + v(n) \tag{1}$$

le premier terme du deuxième membre de cette expression est le signal d'écho reçu.

3

hi représente la réponse impulsionnelle du trajet d'écho échantillonnée aux instants iT.

v(n) représente le bruit présent sur la ligne.

Un annuleur d'écho classique comporte un filtre numérique ayant N coefficients Ci (i = 0...N — 1), à régler pour fournir un signal d'écho synthétique Y(n) tel que :

$$\hat{y}(n): \sum_{i=0}^{N-1} Ci \cdot x(n-i) \tag{2}$$

le nombre N de coefficients du filtre doit être tel que NT soit au moins égale au retard de l'écho par rapport au signal émis qui l'a engendré, soit NT $\geqslant$ 2 Z.

Pour le réglage des coefficients Ci, on forme dans l'annuleur d'écho le signal de différence e(n) entre le signal reçu y(n) et le signal d'écho synthétique $\hat{y}$(n) soit :

$$e(n) = y(n) — \hat{y}(n).$$

En utilisant les formules (1) et (2) ci-dessus, avec i = 0, 1 ... N — 1, on obtient :

$$e(n): \sum_{i=0}^{N-1} (hi - Ci) \cdot x(n-i) + v(n) \tag{3}$$

Les coefficients Ci sont calculés par récurrences successives de façon à minimiser le signal d'erreur.

$$\varepsilon(n): \sum_{i=0}^{N-1} (hi - Ci) \cdot x(n-i) \tag{4}$$

Après un nombre suffisant de récurrences, l'annuleur d'écho converge et l'on obtient $\varepsilon(n) \approx 0$, donc hi$\approx$Ci, de sorte que les coefficients Ci du filtre numérique constituent une approximation de la réponse impulsionnelle hi du trajet d'écho.

On utilise généralement l'algorithme du gradient pour le réglage des coefficients, ce qui conduit pour le réglage des coefficients Ci à la formule de récurrence classique :

$$Ci(n+1): Ci(n) + \alpha \cdot x(n-i) \cdot e(n) \tag{5}$$

Dans cette formule, Ci(n) est un coefficient Ci à un instant nT, qui doit être modifié par le terme de modification $\alpha \cdot x(n — i) \cdot e(n)$ pour former le coefficient modifié Ci(n + 1), utilisable à l'instant (n + 1) T $\cdot \alpha$ est un coefficient inférieur à 1 qui détermine le gain de la boucle d'asservissement.

Souvent pour simplifier la mise en œuvre de l'algorithme, on substitue à e(n) dans la formule de récurrence (5) le signe de e(n) soit Sgn [e(n)]. De plus, on prend généralement un coefficient de la forme $2^{-m}$. La formule de récurrence (5) devient alors :

$$Ci(n+1) = Ci(n) + 2^{-m} \cdot x(n-i) \cdot Sgn\ [e(n)] \tag{6}$$

Avec cette formule (6), dans le cas où le signal de référence x(n) est binaire, la modification des coefficients à chaque instant tel que xT, est une simple incrémentation ou décrémentation par le nombre binaire élémentaire $2^{-m}$. Plus le nombre m est grand, plus le gain de la boucle d'asservissement est faible et plus l'annuleur d'écho est insensible au bruit v(n) présent sur la ligne, mais plus la convergence est lente et plus le nombre d'éléments binaires nécessaires à la représentation des coefficients est grand.

On sait qu'un annuleur d'écho du genre décrit ci-dessus peut converger si l'on utilise un signal de référence x(n) formé d'une séquence pseudoaléatoire répétée cycliquement et si la durée NT, pendant laquelle le filtre stocke des éléments du signal de référence, est telle que le filtre ne stocke pas plus d'une séquence du signal de référence.

On va maintenant montrer comment cette technique d'annulation d'écho est utilisée dans le dispositif de l'invention et adaptée pour conduire à une réalisation extrêmement simple et pour réduire de façon optimale la sensibilité aux bruits.

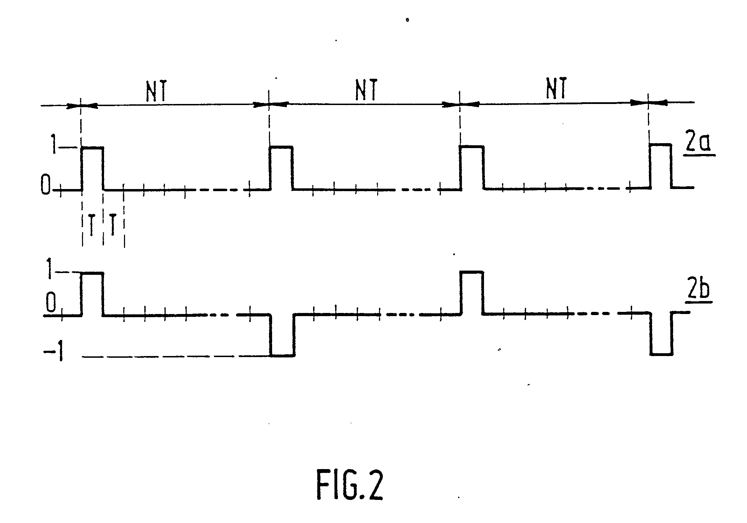

Dans un mode de réalisation de l'invention, la séquence binaire répétée cycliquement et servant à former le signal de référence x(n) ne comporte qu'un seul élément de valeur non nulle égale à 1. Le diagramme 2a sur la figure 2 représente le signal x(n) formé de cette manière. Une telle séquence a le caractère pseudoaléatoire requis pour assurer la convergence d'un annuleur d'écho adaptatif puisqu'elle ne présente intérieurement aucune périodicité. La durée de la séquence est choisie égale à la durée NT de stockage du filtre.

Avec un tel signal de référence, l'expression (2) ci-dessus donnant les calculs à effectuer pour obtenir

chaque échantillon ŷ(n) du signal d'écho synthétique, se simplifie puisque parmi les N échantillons x(n — i) du signal de référence stockés dans la mémoire du filtre numérique de l'annuleur d'écho, un seul n est non nul et vaut 1. Si l'on met les instants d'échantillonnage nT sur la forme nT = KNT + jT, où K entier allant de — ∞ à + ∞ caractérise les périodes de durée NT et j entier allant de 0 à N — 1 caractérise les instants d'échantillonnage à l'intérieur de chaque période NT, l'expression (2) se réduit à :

$$\hat{y}(n) = Ci \qquad\qquad (7)$$

pour les instants nT tels que j = i.

Autrement dit, N échantillons approchés y(n) de la réponse impulsionnelle du trajet d'écho pendant une durée NT peuvent être obtenus simplement en lisant N coefficients Ci stockés dans une mémoire. Ces N échantillons aux instants j = 0, 1 ... N — 1 à l'intérieur d'une période quelconque sont respectivement les coefficients Co, CI ... CN — 1.

Le réglage de ces coefficients Ci est effectué suivant l'algorithme du gradient qui peut être mis en œuvre par l'une des formules de récurrence (5) et (6) comme on l'a vu ci-dessus. Avec le signal de référence décrit ci-dessus, les N coefficients Ci sont modifiés au cours d'une période NT et chaque coefficient Ci n'est modifié qu'une fois par période aux instants nT tels que j = i. La formule de récurrence (6) par exemple peut s'écrire :

$$Ci(K + 1) = Ci(K) + 2^{-m} \, Sgn \, [e(n)] \qquad\qquad (8)$$

Dans cette formule, Ci(K) est le coefficient Ci lu à la période K, à un instant tel que j = i, pour être modifié et Ci (K + 1) est ce coefficient modifié à lire à la période suivante K + 1, à l'instant tel que j = i.

On peut remarquer que dans la formule de récurrence (8), le signal d'erreur e(n) a maintenant la forme très simple e(n) = y(n) — Ci(n), ce qui montre que chaque coefficient est modifié indépendamment des autres coefficients.

De cette manière, la modification d'un coefficient n'est pas affectée par les erreurs de calcul ou les bruits affectant les N — 1 autres coefficients.

Finalement, en utilisant dans le dispositif de l'invention, un annuleur d'écho avec un signal de référence décrit sur le diagramme 2a, on obtient de façon très simple la réponse impulsionnelle du trajet d'écho désirée, en lisant dans une mémoire N coefficients modifiés par récurrences successives suivant la formule (8). Ce dispositif est particulièrement insensible aux bruits en ligne, du fait que les modifications sur chaque coefficient ne sont pas tributaires des autres coefficients.

Au lieu d'utiliser le signal de référence décrit ci-dessus et représenté sur le diagramme 2a, on peut aussi utiliser un signal de référence formé comme l'indique le diagramme 2b, de séquences successives de durée NT et dont l'élément non nul prend alternativement la valeur + 1 et la valeur — 1. Le signal de référence 2b présente la particularité qui peut être parfois intéressante de ne pas comporter de composante continue. Dans ce cas, l'expression (2) ci-dessus donnant y(n) devient :

$$\hat{y}(n) = \pm Ci \qquad\qquad (9)$$

pour les instants nT tels que j = i.

Autrement dit les N échantillons y(n) de la réponse impulsionnelle du trajet d'écho pendant une période NT peuvent être obtenus en lisant N coefficients Ci dans une mémoire et en changeant ou non le signe de ces coefficients selon la parité de la période NT.

Les N coefficients Ci sont modifiés comme on l'a décrit ci-dessus dans le cas d'un signal de référence du type représenté au diagramme 2a, toutefois, en apportant ou non un changement de signe aux coefficients à modifier.

Le dispositif de l'invention suivant le procédé décrit ci-dessus peut être réalisé et fonctionner comme on va maintenant le décrire à l'aide de la figure 1. On se place d'abord dans le cas où le signal de référence x(n) a la forme représentée sur le diagramme 2a. Le nombre d'éléments binaires de chaque séquence est par exemple N = 128 et la durée de chaque bit est T = 1 µs.

Le signal de référence x(n) est fourni par exemple à la sortie de la mémoire 8 qui stocke les N éléments binaires d'une séquence et qui, comme on l'a déjà expliqué, est lue à l'aide du signal d'adresses A1 et du signal de lecture R1. Ce signal de référence x(n) est appliqué à l'extrémité d'émission 5 du circuit de couplage 4, via le convertisseur 10 et l'amplificateur 11.

Le dispositif de l'invention comporte du côté de la voie réception une mémoire 14 dans laquelle N coefficients Ci peuvent être écrits à l'aide d'un signal d'écriture W2, à N adresses caractérisées par i et déterminées par le signal d'adresses A2. Ces N coefficients écrits à ces adresses peuvent y être ensuite lus à l'aide d'un signal de lecture R3 et du signal d'adresses A3. Ces signaux de commande A2, W2 et A3, R3 sont engendrés dans le dispositif de commande 9. Ils sont périodiques. Les signaux de lecture et d'écriture W2 et R3 ont la fréquence 1/T et les signaux d'adresses A2 et A3 ont la fréquence 1/NT, le signal d'adresses A3 pour la lecture étant simplement le signal d'adresse A2 pour l'écriture décalé par exemple en avance de la durée T.

**0 146 175**

Chacun des coefficients Ci(n) lus dans la mémoire à une adresse, à un instant nT tel que i = j, constitue comme on l'a expliqué une valeur approchée ŷ(n) de la réponse impulsionnelle du trajet d'écho, après un nombre suffisant de modifications par récurrences successives. Pour modifier les coefficients selon la formule de récurrence (8), chaque coefficient Ci(n) formé de m + 1 éléments binaires (par exemple m + 1 = 16), est appliqué au convertisseur numérique-analogique 15 qui n'utilise que les l éléments binaires les plus significatifs par exemple l = 12. Chaque échantillon analogique de la valeur approchée y(n) de la réponse impulsionnelle du trajet d'écho est appliqué à l'entrée négative du circuit comparateur 16. A l'entrée positive de ce circuit comparateur est appliqué le signal reçu de la ligne de transmission, filtré à l'aide des filtres 12 et 13 et prenant la valeur y(n) à un instant xT. La sortie du circuit comparateur fournit ainsi à chaque instant nT le signal du signe de y(n) — ŷ(n) soit Sgn [e(n)] selon la notation de la formule (8).

Ce signal est appliqué à une bascule de mise en forme 17 procurant un retard T de sorte qu'à la sortie de cette bascule 17 apparaît à un présent instant nT le signal formé à l'instant précédent (n — 1)T, soit Sgn [e(n — 1)]. Le signal Sgn [e(n — 1)] est appliqué au circuit multiplicateur 18 pour affecter du signe + 'ou du signe — la quantité $2^{-m}$ et former ainsi le terme de modification Sgn [e(n)] $2^{-m}$.

Chaque coefficient Ci(n) lu dans la mémoire à un instant nT est appliqué d'autre part au circuit 19 procurant un retard T, de sorte qu'à cet instant de lecture nT il apparaît à la sortie du circuit 19 le coefficient Ci-1(n — 1) lu précédemment à l'instant (n — 1)T. C'est ce coefficient qui convient pour être modifié du terme de modification Sgn [e(n — 1)] $2^{-m}$. Le circuit additionneur 20 forme la somme de ce terme de modification et du coefficient Ci-1(n — 1). Le coefficient Ci-1 ainsi modifié est inscrit dans la mémoire 14 à l'adresse i — 1, à l'aide du signal d'adresse A2 et du signal d'écriture W2.

Après un nombre de récurrences suffisant, on obtient pratiquement, sous la forme de coefficients Ci enregistrés dans la mémoire 8, les échantillons de la réponse impulsionnelle du trajet d'écho pendant la durée NT d'une séquence. Ces coefficients peuvent être lus ultérieurement pour être traités dans un ordinateur par exemple. Ce traitement peut permettre de déterminer le retard de l'écho par rapport au début d'une séquence afin de localiser le point de réflexion, ainsi que la forme et l'amplitude de l'écho afin de caractériser le défaut de la ligne de transmission.

Afin de réduire le temps de convergence des coefficients vers la réponse impulsionnelle désirée, tout en conservant une bonne stabilité au dispositif, il est possible, suivant une technique connue dans les annuleurs d'écho, de modifier au cours de la convergence la valeur du coefficient $\alpha = 2^{-m}$ fixant l'amplitude des incréments de modification des coefficients. On peut utiliser par exemple trois valeurs de $\alpha$ en commençant par une valeur élevée et en terminant par une valeur faible correspondant à la précision souhaitée pour les coefficients.

Dans le cas où l'on utilise le signal de référence représenté au diagramme 2b, le dispositif de la figure 1 peut convenir, moyennant des modifications très simples. On peut par exemple insérer sur la voie d'émission 2 un circuit multiplicateur 21 représenté en traits pointillés qui multiplie les nombres lus dans la mémoire 8 par — 1, une séquence NT sur deux. Pour cela, le circuit multiplicateur 21 reçoit du générateur de signaux de commande 8, un signal S ayant la fréquence 1/2NT et prenant alternativement les valeurs + 1 et — 1. Du côté de la voie réception, pour former le signal d'écho synthétique ŷ(n) appliqué au circuit comparateur 16, en changeant ou non le signe des coefficients Ci comme on l'a expliqué ci-dessus (voir formule 9), on utilise un circuit multiplicateur 22 qui est disposé sur le trajet des coefficients Ci allant vers le convertisseur 14 et qui reçoit le signal S que l'on vient de définir.

Le dispositif de l'invention que l'on vient de décrire peut être perfectionné en appliquant à la voie d'émission une version filtrée du signal de référence 2a ou 2b. Ce filtre de précorrection, utile pour les lignes de transmission les plus longues, a pour but d'une part de compenser les distorsions d'amplitude et de temps de propagation de la ligne dans la bande de fréquence utile afin de préserver le caractère impulsionnel de l'écho reçu et d'autre part de concentrer l'énergie du signal émis dans la bande de fréquences strictement nécessaire. Pour réaliser un filtre de ce genre, la seule exigence est que sa réponse impulsionnelle s'étende sur moins de la durée NT d'une séquence, de façon que ce signal filtré reste périodique avec la période NT. Pratiquement, un tel filtrage de précorrection sur le signal d'émission peut être réalisé sans augmenter la complexité du dispositif décrit à la figure 1. Il suffit de stocker dans la mémoire 8 N éléments binaires représentant la réponse impulsionnelle du filtre désiré, cette mémoire étant lue à l'aide des signaux de commande A1, R1. Du côté de la voie de réception, aucune modification du dispositif n'est nécessaire.

Avec ce système de filtrage de précorrection, on augmente la portée du dispositif de l'invention pour les lignes les plus longues tandis que pour les lignes les plus courtes il peut être préférable de revenir au dispositif sans filtrage de précorrection. Un signal de commande M appliqué à la mémoire 8 peut permettre d'y lire soit un signal non filtré, soit un signal filtré (avec éventuellement différentes fonctions de filtrage) selon la ligne de transmission à tester.

Un autre perfectionnement qui peut être apporté au dispositif de l'invention tel que décrit jusqu'à présent, consiste à « lisser » chaque coefficient Ci en en calculant la moyenne temporelle, à partir d'un instant où la convergence de coefficients est bien avancée, pendant une durée d'intégration suffisamment longue. Par exemple, le calcul de la moyenne des coefficients Ci peut commencer après $2^{12}$ récurrences de modifications des coefficients, soit environ 500 ms dans l'exemple précité où l'intervalle de temps NT entre les récurrences est égal à 128 $\mu$s. La durée d'intégration des coefficients peut également être de 500

6

0 146 175

ms. L'utilisation des coefficients ainsi lissés pour les mesures d'écho, permet de s'affranchir pratiquement des bruits et dérives à basse fréquence dont peuvent être affectés les coefficients modifiés, notamment les dérives que peuvent produire les courants à fréquence industrielle induits sur la ligne.

Pour mettre en œuvre le lissage des coefficients, le dispositif de la figure 1 comporte un dispositif accumulateur formé d'un circuit additionneur 23 recevant d'une part les coefficients modifiés Ci-1 disponibles à la sortie du circuit additionneur 20, et d'autre part le terme de somme des coefficients $\Sigma$Ci-1 lu dans la mémoire 24 à l'aide du signal de lecture R3 et du signal d'adresses A2. Le nouveau terme de somme formée à la sortie du circuit additionneur 23 est inscrit dans la mémoire 24 à l'aide du signal d'écriture W2 et du signal d'adresses A3. Si les coefficients modifiés Ci-1 appliqués au circuit additionneur 23 ont I bits et si le dispositif accumulateur forme la somme de L coefficients modifiés, les termes somme $\Sigma$Ci-1 lus dans la mémoire 24 ont (I + $\log_2$L) bits. La valeur moyenne

$$Ci - 1 = \frac{1}{L} \sum_{Ci-1}$$

peut être aisément formée sur la borne 25, dans le cas où L est une puissance de 2 (par exemple L = $2^{12}$), en supprimant $\log_2$L bits (12 bits) sur les termes de somme, disponibles à la sortie du circuit additionneur 23. Les coefficients « lissés » Ci-1 à I' bits apparaissant ainsi à la sortie du circuit 23 pendant une période NT, peuvent être utilisés ou stockés dans une mémoire non représentée, après le temps requis pour la convergence du dispositif.

**Revendications**

1. Dispositif destiné à localiser et/ou caractériser un point de réflexion sur une ligne de transmission par l'enregistrement de la réponse impulsionnelle du trajet d'un écho engendré audit point de réflexion en réponse à un signal d'émission appliqué à une extrémité de la ligne, trajet d'écho formé de la partie aller de ligne comprise entre ladite extrémité et le point de réflexion, du point de réflexion et de la partie retour de la ligne comprise entre le point de réflexion et ladite extrémité, ce dispositif comportant une voie d'émission et une voie de réception couplées à la ligne de transmission par un circuit de couplage, le signal d'émission étant déduit d'un signal de référence constitué de séquences binaires de même durée NT au moins égale au double du temps de propagation dans la ligne de transmission, N étant un nombre entier, T étant la durée d'un élément binaire et le temps de propagation dans la ligne de transmission correspondant au trajet unidirectionnel d'une onde parcourant toute la longueur de la ligne de transmission, caractérisé en ce que lesdites séquences binaires ne comportent qu'un seul élément de valeur non nulle égale à 1 (ou alternativement 1 et — 1) et du côté réception, il est prévu une mémoire pour N coefficients Ci (i entier allant de 0 à N — 1) qui sont lus cycliquement à des instants nT = (KN + j)T en vue d'être modifiés par récurrences successives, n entier prenant les valeurs croissantes par incréments de 1, dans une plage de valeurs comprises entre —∞ et ∞, K entier prenant les valeurs, croissantes, par incréments de 1, dans une plage de valeurs comprises entre — ∞ et + ∞, et caractérisant chaque cycle de lecture, j entier allant de 0 à N — 1 et caractérisant l'instant de lecture dans un cycle de lecture, des moyens de comparaison formant à chaque instant nT la différence e(n) entre le signal reçu et chaque coefficient Ci lu et converti en un signal analogique ou le signe de e(n), Sgn [e(n)], des moyens étant prévus pour modifier chaque coefficient Ci une fois par cycle de lecture, à des instants tels que j = i, au moyen d'un terme de modification additif égal à α · e(n) ou α · Sgn [e(n)], α étant un coefficient inférieur à 1, les coefficients lus étant après chaque modification inscrits dans ladite mémoire, les coefficients Ci inscrits dans la mémoire constituant après un nombre suffisant de modifications, les valeurs (ou les valeurs au signe près) à des instants iT de la réponse impulsionnelle du trajet d'écho.

2. Dispositif selon la revendication 1, caractérisé en ce que le coefficient α est de la forme $2^{-m}$, m étant un nombre entier.

3. Dispositif selon l'une des revendications 1 ou 2, caractérisé en ce que le signal d'émission est une version filtrée du signal de référence, avec une fonction de filtrage déterminée pour compenser au moins de façon approximative les distorsions produites par les lignes de transmission à tester, la réponse impulsionnelle correspondant à cette fonction de filtrage s'étendant au plus sur la durée NT de l'une des séquences composant le signal de référence.

4. Dispositif selon la revendication 3, caractérisé en ce que la version filtrée du signal de référence est obtenue par la lecture cyclique d'une mémoire dans laquelle est enregistrée la réponse impulsionnelle correspondant à ladite fonction de filtrage.

5. Dispositif selon l'une des revendications 1 à 4, caractérisé en ce qu'il comporte un circuit accumulateur pour former, à partir d'un certain temps et pendant un certain nombre de récurrences, la somme de chacun des coefficients Ci modifiés, les valeurs moyennes des coefficients Ci étant déduites des sommes ainsi formées pour être utilisées comme valeurs de la réponse impulsionnelle dudit trajet d'écho.

7

**Claims**

1. A device intended to localize and/or characterize a reflection point in a transmission line by recording the impulse response of the path of an echo produced at the said reflection point in response to a send signal applied to one end of the line, the echo path being formed by the outgoing portion of the line comprised between the said end and the reflection point, the reflection point and the return portion of the line comprised between the reflection point and the said end, this device comprising a send path and a receive path coupled to the transmission line by a coupling circuit, the send signal being derived from a reference signal constituted by binary sequences of the same duration NT at least equal to double the propagation time in the transmission line, N being an integer, T being the duration of a binary element and the propagation time in the transmission line corresponding to the unidirectional path of a wave passing through the whole length of the transmission line, characterized in that the said binary sequences comprise only a single binary element of a non-zero value which is equal to 1 (or alternatively, 1 and — 1) and that on the receive side, there is provided a memory for N coefficients $C_i$ (i being an integer between 0 and $N — 1$) which are read cyclically at instants $nT = (KN + j)T$, in order to be iteratively modified, n being an integer assuming the values increasing by increments of 1, in a range of values comprised between — and +, K being an integer assuming the values increasing by increments of 1, in a range of values comprised between — and +, and characterizing each read cycle, i being an integer going from 0 to $N — 1$ and characterizing the read instant in a read cycle, comparator means forming at each instant nT the difference e(n) between the received signal and each coefficient $C_i$ read out and converted into an analog signal or the sign of e(n), Sgn [e(n)], means being provided for modifying each coefficient $C_i$ once per read cycle, at instants such that $j = i$, by means of an additive modification term equal to $\alpha \cdot e(n)$ or $\alpha \cdot$ Sgn [e(n)], $\alpha$ being a coefficient less than 1, the read coefficients being written into the said memory after each modification, the coefficients $C_i$ written into the memory constituting, after a sufficient number of modifications, the values (or the values apart from their sign) at instants iT of the impulse response of the echo path.

2. A device as claimed in Claim 1, characterized in that the coefficient $\alpha$. has the form of $2^{-m}$, m being an integer.

3. A device as claimed in one of the Claims 1 or 2, characterized in that the send signal is a filtered version of the reference signal, having a specific filtering function for compensating at least approximately for the distorsions caused by the transmission lines to be tested, the impulse response corresponding to this filtering function extending at most over the duration NT of one of the sequences constituting the reference signal.

4. A device as claimed in Claim 3, characterized in that the filtered version of the reference signal is obtained by cyclically reading out a memory into which the impulse response corresponding to the said filtering function has been written.

5. A device as claimed in one of the Claims 1 to 4, characterized in that it comprises an accumulator circuit for forming, as from a given period and during a given number of iterations, the sum of each of the modified coefficients $C_i$, the mean values of the coefficients $C_i$ being derived from the sums formed thus in order to be used as values of the impulse response of the said echo path.

**Patentansprüche**

1. Anordnung zur Lokalisierung und/oder Kennzeichnung einer Reflexionsstelle auf einer Übertragungsleitung durch Aufzeichnung der Impulsantwort einer Strecke eines Echos, das an der genannten Reflexionsstelle in Antwort auf ein Sendesignal erzeugt wird, das einem Ende der Leitung zugeführt wird, wobei die Echostrecke durch den hingehenden Teil der Leitung, der zwischen dem genannten Ende und der genannten Reflexionsstelle liegt, die Reflexionsstelle und den rückgehenden Teil der Leitung, der zwischen der genannten Reflexionsstelle und dem genannten Ende liegt, gebildet wird, wobei diese Anordnung mit einer Sendestrecke sowie einer Empfangsstrecke versehen ist, die durch einen Koppelkreis mit der Übertragungsleitung gekoppelt sind, wobei das Sendesignal von einem Bezugssignal abgeleitet wird, das aus binären Folgen gleicher Dauer NT besteht, die mindestens der doppelten Fortpflanzungszeit in der Übertragungsleitung entspricht, wobei N eine ganze Zahl ist, während T die Schrittdauer eines Binärelementes ist und die Fortpflanzungszeit in der Übertragungsleitung einer Einrichtungsstrecke einer die ganze Länge der Übertragungsleitung durchlaufenden Welle entspricht, dadurch gekennzeichnet, dass die genannten binären Folgen nur ein einziges Element mit einem Nicht-Null-Wert gleich 1 (oder abwechselnd 1 und — 1) aufweisen und dass empfangsseitig ein Speicher für N Koeffizienten $C_i$ vorgesehen ist (wobei i eine ganze Zahl ist, die zwischen 0 und $N — 1$ liegen kann), die zu Zeitpunkten $nT = (KN + j)T$ zyklisch gelesen werden um iterativ geändert zu werden, wobei n eine ganze Zahl ist, die um jeweils 1 ansteigende Werte annehmen kann in einem Wertbereich zwischen $— \infty$ und $\infty$, wobei K eine ganze Zahl ist, die um jeweils 1 ansteigende Werte annehmen kann in einem Wertbereich zwischen $— \infty$ und $+ \infty$ und die jeden Lesezyklus kennzeichnet, wobei j eine ganze Zahl ist, die zwischen 0 und $N — 1$ liegen kann und den Lesezeitpunkt in einem Lesezyklus kennzeichnet, wobei Vergleichsmittel zu jedem Zeitpunkt nT die Differenz e(n) zwischen dem empfangen Signal und jedem gelesenen und in eine analoges Signal umgewandelten Koeffizienten Ci oder in das Zeichen e(n), Sgn [e(n)], bilden und wobei Mittel vorgesehen sind um jeden Koeffizienten Ci einmal pro Lesezyklus zu ändern zu derartigen Zeitpunkten, dass j = i ist, mit Hilfe eines additiven Änderungsterms gleich dem Wert $\alpha \cdot e(n)$ oder $\alpha \cdot$ Sgn [e(n)], wobei $\alpha$ ein Koeffizient kleiner als 1 ist, wobei die gelesenen Koeffizienten nach jeder Anderung in den genannten Speicher eingeschrieben werden, wobei die in den Speicher eingeschriebenen Koeffizienten Ci nach einer ausreichenden Anzahl Änderungen die Werte (oder die Werte ohne Vorzeichen) zu den Zeitpunkten iT der Impulsantwort der Echostrecke bilden.

2. Anordnung nach Anspruch 1, dadurch gekennzeichnet, dass der Koeffizient $\alpha$ die Form $2^{-m}$ aufweist, wobei m eine ganze Zahl ist.

3. Anordnung nach Anspruch 1 oder 2, dadurch gekennzeichnet, dass das Sendesignal eine gefilterte Version des Bezugssignals ist mit einer bestimmten Filterfunktion zum wenigstens annähernd Kompensieren der durch die zu überprüfenden Übertrag- ungsleitungen verursachten Verzerrungen, wobei die dieser Filterfunktion entsprechende Impulsantwort sich höchstens über die Dauer NT einer der das Bezugssignal bildenden Folgen erstreckt.

4. Anordnung nach Anspruch 3, dadurch gekennzeichnet, dass die gefilterte Version des Bezugssignals erhalten wird, durch zyklisches Anlesen eines Speichers, in dem die der genannten Filterfunktion entsprechende Impulsantwort gespeichert ist.

5. Anordnung nach einem der Ansprüche 1 bis 4, dadurch gekennzeichnet, dass sie einen Akkumulator aufweist zum nach einer bestimmten Zeit und während einer bestimmten Anzahl Iterationen Bilden der Summe jedes der geänderten Koeffizienten Ci, wobei die Mittelwerte der Koeffizienten Ci von den auf diese Weise gebildeten Summen abgeleitet werden um als Werte der Impulsantwort der genannten Echostrecke verwendet zu werden.

0 146 175

FIG.1

FIG.2